Europäisches Patentamt

European Patent Office

Office européen des brevets

(11) Publication number: **0 436 126 A2**

# EUROPEAN PATENT APPLICATION

(21) Application number: 90123106.8

(22) Date of filing: 03.12.90

(51) Int. Cl.5: **H01L 23/495**

(30) Priority: 04.12.89 JP 313411/89

(43) Date of publication of application:
**10.07.91 Bulletin 91/28**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Yamaji, Yasuhiro, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Resin-encapsulated semiconductor device.

(57) An insulating resin layer (13), such as a polyimide-resin tape, is formed on selected portions of a thin metal plate (12). Inner leads (14) and outer leads (15), which are integrally formed by etching a copper foil, are bonded to the resin layer (13). A semiconductor chip (17) is die-bonded to that portion of the metal plate (12) which is not covered by the resin layer (13). Metal wires (19) connect the outer leads (15) to the electrode pads (18) formed on the upper surface of the chip (17). The chip 17 is encapsulated by an envelope (20) made of an epoxy resin.

EP 0 436 126 A2

## RESIN-ENCAPSULATED SEMICONDUCTOR DEVICE

This invention relates to a resin-encapsulated semiconductor device and, more particularly to a semiconductor device comprising a thin metal plate and a semiconductor chip connected to the metal plate by means of die-bonding.

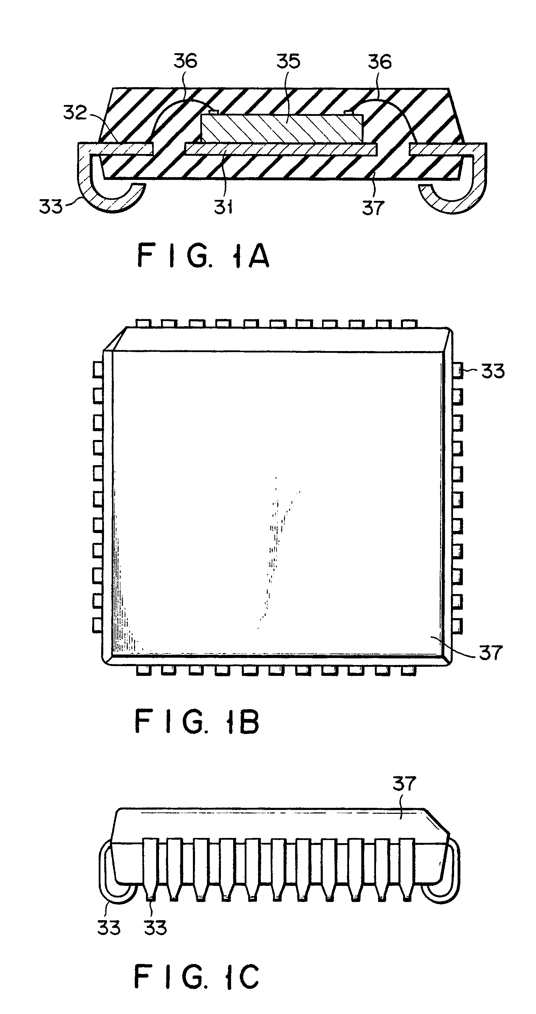

A resin-encapsulated semiconductor device is known which has the structure illustrated in Fig. 1A to 1C. Fig. 1A is a sectional view, Fig. 1B is a plan view, and Fig. 1C is a side view -- all showing the device. The semiconductor device has a lead frame which has a die pad 31, inner leads 32, and outer leads 33. The die pad 32, the inner leads 32 and the outer leads 33 are formed by stamping thin metal plates made of an Fe-Ni alloy generally known as "42 alloy," copper, or the like.

The semiconductor device further comprises a semiconductor chip 35 mounted on the die pad 31. The inner leads 32 are discrete from the die pad 31. The inner leads 32 are connected to the semiconductor chip 35 by metal wires 36 having a diameter of tens of microns. The die pad 31, the inner leads 32, the semiconductor chip 35 are sealed within an envelope 37 which is made of epoxy resin by means of molding.

The heat the chip 35 generates while operating is radiated outside through the metal wire 36 which are very thin, or through the envelope 37 which is made of a resin having a small thermal conductivity. Hence, the heat accumulates within the semiconductor device, inevitably heating the chip excessively. Consequently, the device will operate but a low speed, will likely be thermally damaged or broken, or will have but a short lifetime.

Recently, a resin-encapsulated semiconductor device has been developed, in which a heat sink made of metal is connected to a die pad, and heat-radiating fins protrude from the envelope, in order to promote heat radiation. The process of assembling a device of this type is so complex that the manufacturing cost of the device is very high.

The object of the present invention is to provide a resin-encapsulated semiconductor device which can radiate heat with high efficiency and can be manufactured by a simple assembling process and, thus, at low cost.

According to the invention, there is provided a resin-encapsulated semiconductor device comprising: a thin metal plate; an insulating member formed on the metal plate; a lead-frame pattern made of a conductive thin film and comprising a plurality of inner leads formed on the insulating member, and a plurality of outer leads formed on the insulating member and integrally with the inner leads; a semiconductor chip fixed at a predetermined position in the lead-frame pattern and having a plurality of electrode pads; connecting means electrically connecting the electrode pads of the semiconductor chip to the inner leads of the lead-frame pattern; and an envelope made of resin and encapsulating the entire semiconductor chip.

This invention can be more fully understood from the following detailed description when taken in conjunction with the accompanying drawings, in which:

Fig. 1A is a sectional view showing a conventional resin-encapsulated semiconductor device;

Fig. 1B is a plan view showing the conventional semiconductor device;

Fig. 1C is a side view illustrating the conventional semiconductor device;

Fig. 2A is a sectional view showing a semiconductor device according to a first embodiment of the present invention;

Fig. 2B is a plan view illustrating the lead frame incorporated in the device shown in Fig. 2A;

Fig. 2C is a sectional view showing the lead frame incorporated in the device shown in Fig. 2A;

Fig. 2D is a plan view of the device shown in Fig. 2A;

Fig. 3 is a sectional view showing a semiconductor device according to a second embodiment of the present invention;

Fig. 4A is a sectional view representing a semiconductor device according to a third embodiment of the invention;

Fig. 4B is a plan view showing part of the device shown in Fig. 4A;

Fig. 5 is a sectional view showing a semiconductor device according to a fourth embodiment of the present invention;

Fig. 6 is a sectional view showing a semiconductor device according to a fifth embodiment of the present invention; and

Fig. 7 is a sectional view showing a semiconductor device according to a sixth embodiment of the present invention.

Embodiments of the present invention will now be described, with reference to the accompanying drawings.

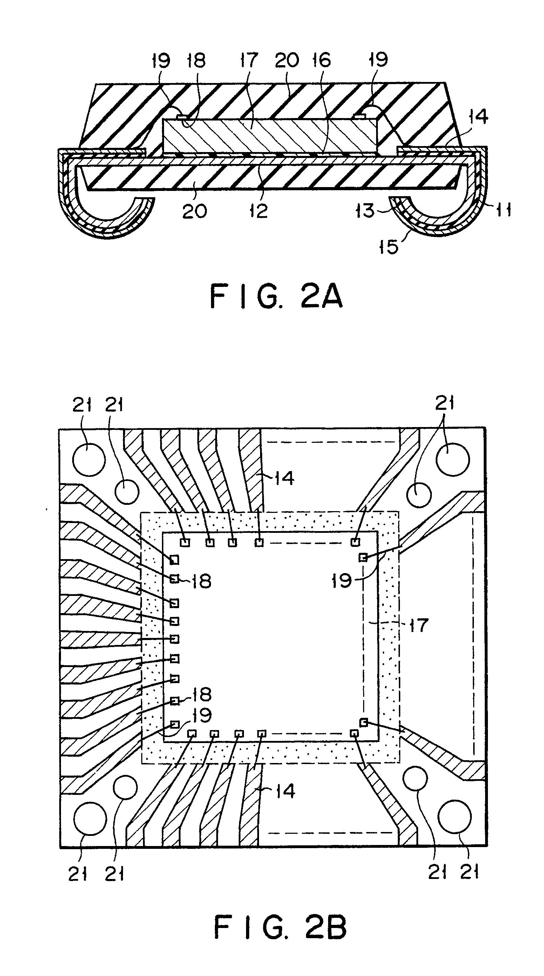

Fig. 2A through Fig. 2D illustrate a first embodiment of the invention, which is a semiconductor device of PLCC (Plastic Leaded Chip Carrier) type.

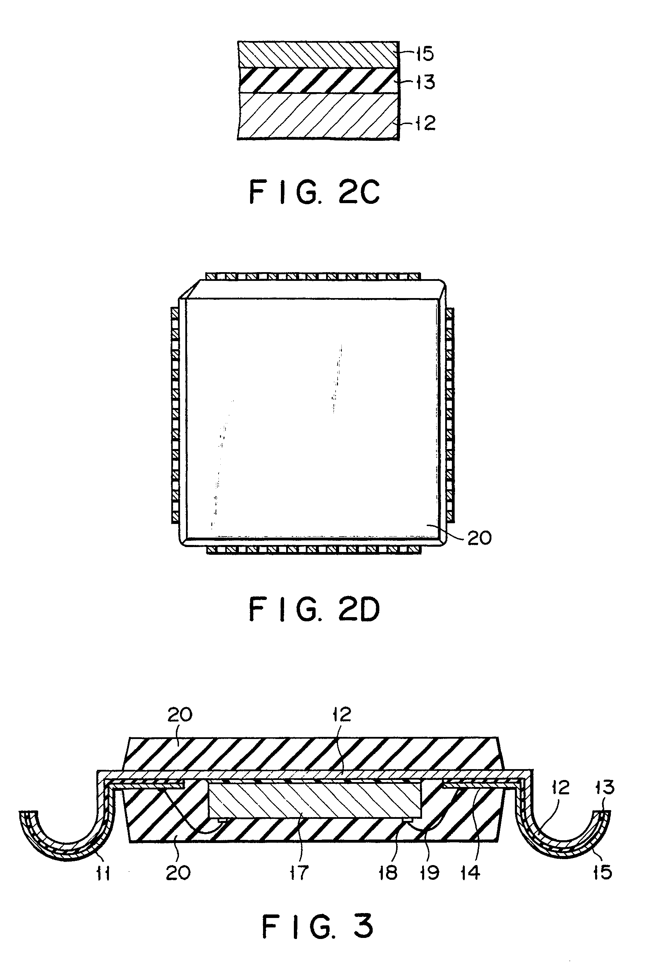

As is shown in Figs. 2A, 2B, and 2C, the lead frame 11 of this semiconductor device comprises a thin metal plate 12, an insulating resin layer 13 formed on the metal plate 12, inner leads 14 formed on the resin layer 13, and outer leads 15 formed on the resin layer 13 and integrally with the inner leads 14. The metal plate 12 is made of copper, an Fe-Ni alloy called "42 alloy," or the like, and having a thickness ranging from 0.1 mm to 0.25 mm. The resin layer 13 is, for example, a tape made of polyimide resin. The inner lead 14 and outer leads 15 have been formed by bonding a copper layer on the resin layer 13 and etching the copper layer.

As is evident from Figs. 2A and 2B, the semiconductor device further comprises a bonding layer 16, a semiconductor chip 17, a plurality of electrode pads 18, a wires 19, and a square envelope 20. The bonding layer 16 is made of neither resin or metal and formed on that portion of the metal plate 12 where neither the inner leads 14 nor the outer leads 15 are mounted. The semiconductor chip 17, which is square, is secured to the bonding layer 16 by means of die-bonding. The electrode pads 18 are formed on the chip 17, along the four edges thereof. The wires 19, which have a diameter of tens of microns, electrically connect the inner leads 14 to the electrode pads 18. The envelope 20 is made of epoxy resin or the like by means of molding, and encapsulating the entire chip 17. As is shown in Fig. 2B, those portions of the thin metal layer 12, which protrude from the four sides of the envelope 20 and on which the outer leads 15 are formed, are bent in the form of letter J.

As is illustrated in Fig. 2B, two through-holes 21 are made in each corner of the metal plate 12. These holes 21 allow the passage of molten resin while the envelope 20 is being formed by means of transfer molding, such that the resin is applied on both sides of the metal plate 12.

Generally, if a resin-encapsulated semiconductor device is mounted on a printed circuit board, a greater part of the heat generated by the device propagates through the outer leads, and only a fraction of the heat passes through the envelope formed by molding. Hence, the heat cannot be radiated efficiently. By contrast, heat can be efficiently radiated from the resin-encapsulated semiconductor device illustrated in Figs. 2A to 2D. This is because the heat generated by the chip 17 radiates outside through the metal plate 12 which is not stamped to form leads. First, the head is first transmitted from the chip 17 to that portion of the plate 12 which is located within the envelope 20. Then, it is transmitted to the edge portions of the plate 12 which protrude from envelope 20 and on which outer leads 15 are formed. The edge portions of the metal plate 12 function as heat-radiating fins. Obviously, the heat which the chip 17 generates can be radiated into the atmosphere with high efficiency. Hence, the device requires no fins designed exclusively for radiating the heat and can, therefore, be manufactured easily at low cost. The efficiency of radiating the heat will be increased if cooled air is applied to the envelope 20.

Fig. 3 is a sectional view illustrating an resin-encapsulated semiconductor device according to a second embodiment of the present invention. This device is different from the device shown in Figs. 2A to 2D in two respects. First, the semiconductor chip 17 is die-bonded to the lower surface of the metal plate 12, not to the upper surface thereof as in the semiconductor device shown in Figs. 2A to 2D. Second, the outer leads 15 are bent in a different fashion.

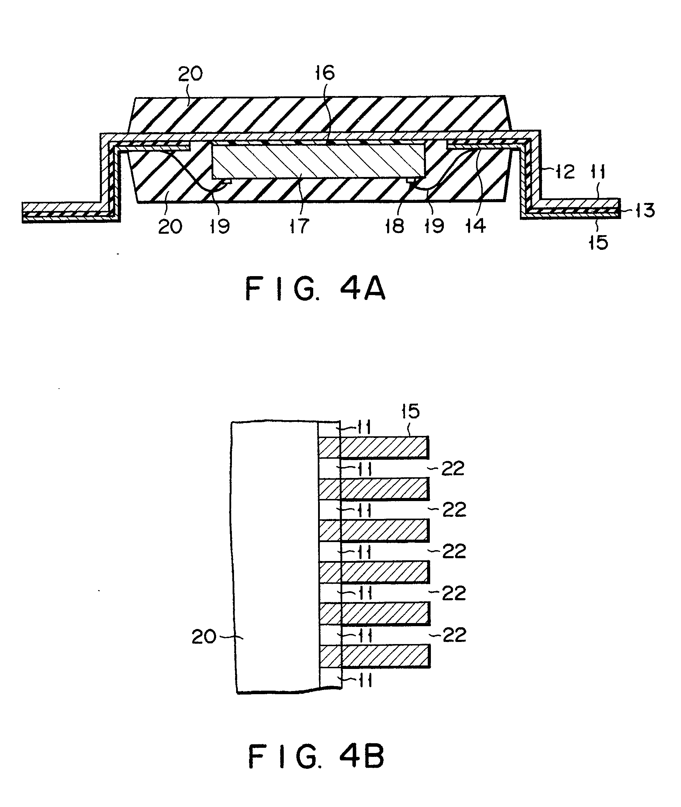

Figs. 4A and 4B illustrate a resin-encapsulated semiconductor device of QFP (Quad Flat Package) type, which is a third embodiment of the present invention. The same components as those of the device shown in Fig. 2 are denoted at the same numerals in Figs. 4A and 4B, and will now be described in detail in the following description.

As is shown in Fig. 4A, the edge portions of a metal plate 12, which protrude from an envelope 20 and on which outer leads 15, are formed are bent in the form of letter L. Further, as is evident from Fig. 4B, each edge portion of the plate 12 has elongated notches 22 extending parallel to one another. These elongated notches 22 isolate the outer leads 15 from one another. Due to this isolation of the outer leads 15, so-called solder bridging is prevented, whereby there will be no short-circuiting among the leads 15.

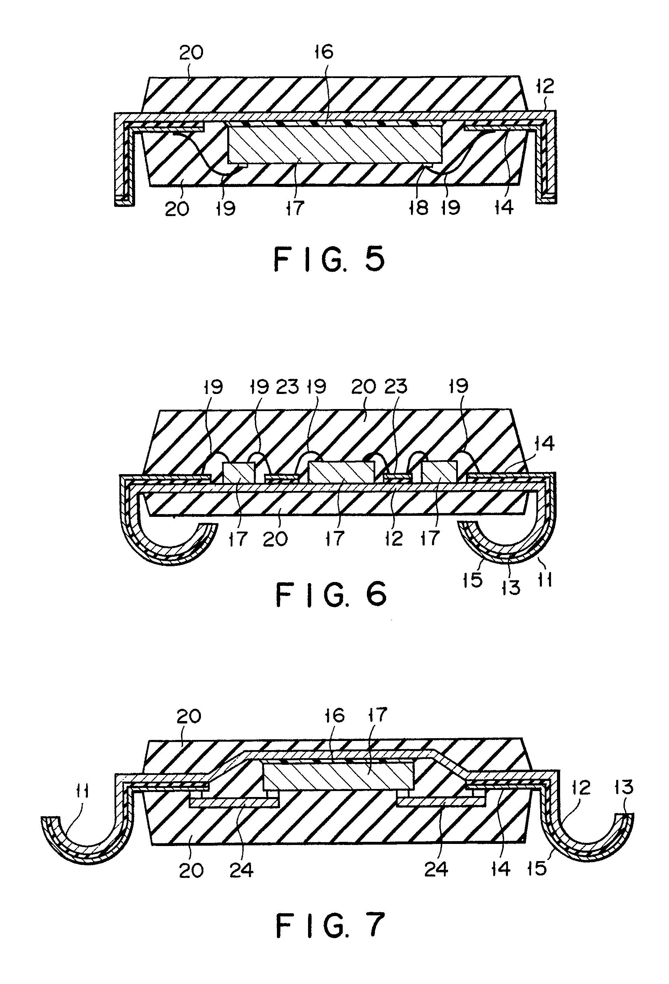

Fig. 5 is a sectional view of a resin-encapsulated semiconductor device of QFP type, which is a fourth embodiment of the present invention. This device differs from the device shown in Figs. 4A and 4B, only in that the horizontal parts of the L-shaped edges of the metal plate 12 are cut off, leaving the vertical parts there of only, which extend parallel to the sides of the envelope 20.

Fig. 6 is a sectional view illustrating a resin-encapsulated semiconductor device of PLCC type, which is a fifth embodiment of the present invention. This device is different from the device shown in Figs. 2A to 2D in three respects. First, the copper layer formed on the metal plate 12 is etched, forming not only inner leads 14 and outer leads 15, but also connecting pads 23. Second, a plurality of semiconductor chips 17 are die-bonded to the upper surface of the metal plate 12. Third, the electrode pads 18 of any two adjacent chips 17 are connected to the same bonding pad 23 by means of bonding wires 19, whereby the adjacent chips 17 are electrically connected to each other.

Fig. 7 is a sectional view of a resin-encapsulated semiconductor device which is a sixth embodiment of the present invention. This device is characterized by the use of a TAB (Tape Automated Bonding) tape comprised of a resin film and wiring strips 24 formed on the resin film. It is the wiring pattern 24 that connects the chip 17 to the inner leads 14, not bonding wires 19 as in the first to fifth embodiments described above. Since the wiring strips 24 are arranged at shorter intervals than bonding wires, the semiconductor chip 17 can be one having a relatively great number of pins.

The present invention is not limited to the embodiments described above. Various changes and modifications are possible, without departing the scope and spirit of the invention. For instance, the layer 13 can be made of any other material than polyimide resin, so far as the material is electrically insulative. It can be made of ceramics which are thermally conductive enough to promote heat radiation. Further, the inner leads 14 can be gold- or silver-plated, and the bonding wires 19 can be connected to the gold or silver layers, ohinstead of being bonded directly to the inner leads 14 as is practiced in the embodiments described above.

As is described above, the the present invention can provide a resin-encapsulated semiconductor device which can radiate heat with high efficiency and can be manufactured by a simple assembling process and, thus, at low cost.

Reference signs in the claims are intended for better understanding and shall not limit the scope.

## Claims

1. A resin-encapsulated semiconductor device characterized by comprising:

    a thin metal plate (12);

    an insulating member (13) formed on the metal plate;

    a lead-frame pattern (11) made of a conductive thin film and comprising a plurality of inner leads (14) formed on the insulating member, and a plurality of outer leads (15) formed on the insulating member and integrally with the inner leads (14);

    a semiconductor chip (17) fixed at a predetermined position in the lead-frame pattern (11) and having a plurality of electrode pads (18);

    connecting means (19) electrically connecting the electrode pads (18) of the semiconductor chip (17) to the inner leads (14) of the lead-frame pattern (11); and

    an envelope (20) made of resin and encapsulating the entire semiconductor chip (17).

2. A resin-encapsulated semiconductor device according to claim 1, characterized in that said metal plate (12) has a plurality of through-holes, and the resin is applied via these through-holes to both sides of said metal plate (12).

3. A resin-encapsulated semiconductor device according to claim 1, characterized in that those portions of said metal plate (12) on which said outer leads (15) are formed are bent and have a cross section shaped like letter J.

4. A resin-encapsulated semiconductor device according to claim 1, characterized in that said connecting means are metal wires (19).

5. A resin-encapsulated semiconductor device according to claim 1, characterized in that said connecting means are wiring strips (24) formed on a TAB tape.

6. A resin-encapsulated semiconductor device according to claim 1, characterized in that those portions of said metal plate (12) on which said outer leads (15) are formed are bent and have a cross section shaped like an inverted J.

7. A resin-encapsulated semiconductor device according to claim 1, characterized in that those portions of said metal plate (12) on which said outer leads (15) are formed are bent and have a cross section shaped like letter L.

8. A resin-encapsulated semiconductor device according to claim 5, characterized in that those portions of said metal plate (12) which protrude from said envelope (20) and on which no outer leads are mounted have elongated notches (22), and these elongated notches (22) isolate the tips of said outer leads (15) from one another.

9. A resin-encapsulated semiconductor device characterized by comprising:

    a thin metal plate (12);

    an insulating member (13) formed on the metal plate;

    a lead-frame pattern (11) made of a conductive thin film and comprising a plurality of inner leads (14) formed on the insulating member, a plurality of outer leads (15) formed on the insulating member and integrally with the inner leads (14), and a plurality of wiring strips (24);

    a plurality of semiconductor chips (17) fixed at predetermined positions in the lead-frame pattern (11) and having a plurality of electrode pads (18);

    connecting means (19) electrically connecting the electrode pads (18) of the semiconductor chips (17), the inner leads (14) of the lead-frame pattern (11), and said wiring strips (24), thereby connecting semiconductor chips (17) to one another; and

an envelope (20) made of resin and encapsulating the entire semiconductor chip (17).

36     35     36

32

33

31     37

F I G. 1A

33

37

F I G. 1B

37

33   33

F I G. 1C

F I G. 2A

F I G. 2B

F I G. 2C

F I G. 2D

F I G. 3

F I G. 4A

F I G. 4B

F I G. 5

F I G. 6

F I G. 7